# EUROPEAN PATENT APPLICATION

(11) **EP 4 597 020 A1**
(43) Date of publication of application: **06.08.2025**
(21) Application number: 25155318.6
(22) Date of filing: 31.01.2025
(51) Int. Cl.: F28F 3/12, F28D 15/04, H01L 23/427, F28D 15/02

(54) **2D VAPOR CHAMBER**

(30) Priority: 01.02.2024 CN 202410147844
(71) Applicant: Purple Cloud Development Pte. Ltd., Singapore 128424 (SG)
(72) Inventor: WANG, XUE MEI, Hui Zhou (CN); HAO, YU WEI, Hui Zhou (CN)
(74) Representative: Grünecker Patent- und Rechtsanwälte PartG mbB

(57) **Abstract**

A 2D vapor chamber may include a first plate, evaporator wick structure, second plate, condenser wick structure, and plurality of heat pipes. The first plate includes a first surface and plurality of chamber walls extending from the first surface and having second and third chamber walls. The evaporator wick structure is disposed on the first surface. The condenser wick structure is disposed on a second surface of the second plate. The plurality of heat pipes includes a plurality of second heat pipes disposed through the second chamber wall and plurality of third heat pipes disposed through the third chamber wall. The second plate is coupled to the plurality of chamber walls and plurality of heat pipes. Each plurality of heat pipes includes an inner chamber surface and pipe wick structure. The pipe wick structure is disposed on the inner chamber surface and coupled to the evaporator wick structure.

## Description

### TECHNICAL FIELD

The present disclosure is related to thermal management of electronic systems in general and more particularly but not limited to 2D vapor chambers.

### BACKGROUND OF THE INVENTION

With the increase of the processing speed and performance of electronic components, such as application-specific integrated circuits (ASICs) and central processing units (CPU), the amount of heat generated during operation of the electronic component increases. The heat generation increases the temperature of the electronic component and, if the heat cannot be dissipated effectively, reliability and performance of the electronic component are reduced.

To prevent overheating of an electronic component of a thin and compact electronic device, a 2D vapor chamber may be used. The generated heat of the electronic component is conducted through a limited area of the electronic component to a larger area of the 2D vapor chamber, and the generated heat can be inefficiently distributed along the 2D vapor chamber. Consequently, the 2D vapor chamber may not adequately cool the electronic component, potentially causing the electronic component to overheat.

### SUMMARY OF THE INVENTION

The present disclosure provides a 2D vapor chamber having extension portions and extension wick portions of a plurality of heat pipes, speeding up transport of working fluid back to a heat source.

The invention is as defined in the appended claims. In some aspects, the techniques described herein relate to a 2D vapor chamber, including a first plate, an evaporator wick structure, a second plate, a condenser wick structure, and a plurality of heat pipes. The first plate includes a first surface, a plurality of chamber walls, and a plurality of support structures. The plurality of support structures is coupled to and extends from the first surface. The plurality of chamber walls surrounds and extends from a perimeter of the first surface. The plurality of chamber walls includes a first plate perimeter ledge opposite the perimeter. The plurality of chamber walls includes a second chamber wall and a third chamber wall opposite the second chamber wall. The second chamber wall includes a plurality of second cut outs and the third chamber wall includes a plurality of third cut outs. The evaporator wick structure includes a first surface wick portion disposed on the first surface. The second plate includes a second surface and a second plate perimeter portion. The second plate perimeter portion surrounds the second surface and the second plate perimeter portion is coupled to the first plate perimeter ledge. The condenser wick structure is disposed on the second surface. The plurality of heat pipes includes a plurality of second heat pipes and a plurality of third heat pipes. Each plurality of heat pipes respectively includes an inner chamber surface and a pipe wick structure. The pipe wick structure is disposed on the inner chamber surface. Each plurality of second heat pipes respectively abuts each plurality of second cut outs and the second plate perimeter portion and extends in a second direction from the second chamber wall. Each plurality of third heat pipes respectively abuts each plurality of third cut outs and the second plate perimeter portion and extends in a third direction from the third chamber wall. The pipe wick structure is coupled to the evaporator wick structure.

In some aspects, the techniques described herein relate to a 2D vapor chamber, wherein the first plate and the second plate define an interior cavity. The interior cavity includes a heat transfer portion and a vapor portion. The heat transfer portion is centrally disposed in the interior cavity from a central first surface to a central second surface. The vapor portion surrounds the heat transfer portion from a surrounding first surface to a surrounding second surface and from the heat transfer portion to the plurality of chamber walls. Each plurality of heat pipes is respectively fluidly coupled to the interior cavity.

In some aspects, the techniques described herein relate to a 2D vapor chamber, further including a core condenser wick structure. The core condenser wick structure is coupled to and extends from the condenser wick structure. The core condenser wick structure is disposed in the heat transfer portion.

In some aspects, the techniques described herein relate to a 2D vapor chamber, wherein the plurality of support structures abuts the second surface.

In some aspects, the techniques described herein relate to a 2D vapor chamber, wherein each plurality of heat pipes respectively includes a closed end, an open end, and a connector portion. The open end is opposite the closed end and the connector portion is coupled to the open end. The connector portion of each plurality of second heat pipes respectively abuts each plurality of second cut outs and the second plate perimeter portion. The connector portion of each plurality of third heat pipes respectively abuts each plurality of third cut outs and the second plate perimeter portion.

In some aspects, the techniques described herein relate to a 2D vapor chamber, wherein the first plate includes a plurality of heat transfer structures. Each plurality of heat transfer structures is coupled to and extends from the first surface in the heat transfer portion. One or more plurality of heat transfer structures is integrally formed with one or more plurality of support structures.

In some aspects, the techniques described herein relate to a 2D vapor chamber, wherein each plurality of heat transfer structures respectively includes a heat structure length and a cuboid shape. The heat structure length includes a length and the cuboid shape includes a shape. Each plurality of heat transfer structures is parallel disposed on the first surface in the heat transfer portion with the second direction and with the third direction, longitudinally.

In some aspects, the techniques described herein relate to a 2D vapor chamber, wherein one or more plurality of heat pipes respectively includes an extension portion. The extension portion includes a bottom surface and an exposed inner chamber surface. The pipe wick structure includes a pipe wick portion and an extension wick portion. The pipe wick portion is disposed on the inner chamber surface. The extension wick portion is disposed on the exposed inner chamber surface. The extension wick portion is coupled to the pipe wick portion and coupled to the evaporator wick structure.

In some aspects, the techniques described herein relate to a 2D vapor chamber, wherein the bottom surface is coupled to the first surface. In some aspects, the techniques described herein relate to a 2D vapor chamber, wherein the bottom surface is coupled to the evaporator wick structure.

In some aspects, the techniques described herein relate to a 2D vapor chamber, wherein the evaporator wick structure includes a heat transfer wick portion. The heat transfer wick portion is disposed on the plurality of heat transfer structures. The extension wick portion is coupled to the heat transfer wick portion.

In some aspects, the techniques described herein relate to a 2D vapor chamber, wherein the extension portion is respectively coupled to the plurality of heat transfer structures. In some aspects, the techniques described herein relate to a 2D vapor chamber, wherein the extension portion includes a connector end and a cavity end. The cavity end includes a base cut out. The connector end is coupled to the connector portion and the base cut out abuts the plurality of heat transfer structures.

In some aspects, the techniques described herein relate to a 2D vapor chamber, wherein the evaporator wick structure includes at least one of a grooved wick, a sintered metal powder wick, a metal mesh wick, and a sintered ceramic powder wick, and any of a foregoing combination.

In some aspects, the techniques described herein relate to a 2D vapor chamber, wherein the condenser wick structure includes at least one of a grooved wick, a sintered metal powder wick, a metal mesh wick, and a sintered ceramic powder wick, and any of a foregoing combination.

In some aspects, the techniques described herein relate to a 2D vapor chamber, wherein the pipe wick structure includes at least one of a grooved wick, a sintered metal powder wick, a metal mesh wick, and a sintered ceramic powder wick, and any of a foregoing combination.

In some aspects, the techniques described herein relate to a 2D vapor chamber, further including a vapor gap. The vapor gap is respectively between the extension portion and the plurality of heat transfer structures.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of 2D vapor chambers incorporating aspects of the presently disclosed principles are illustrated by way of example, and not by way of limitation.
Fig. 1A illustrates a 2D vapor chamber according to one embodiment of the present disclosure.
Fig. 1B is an exploded view of the 2D vapor chamber of Fig. 1A, according to one embodiment of the present disclosure.
Fig. 2 illustrates a first plate of the 2D vapor chamber of Figs. 1A and 1B, according to an embodiment of the present disclosure.
Fig. 3 illustrates circle A of a plurality of heat pipes with the first plate of the 2D vapor chamber of Figs. 1A and 1B, according to an embodiment of the present disclosure.
Fig. 4 is a detailed view of circle A of Fig. 3, according to an embodiment of the present disclosure.
Fig. 5 is a detailed view of a wick structure of the 2D vapor chamber of Figs. 1A and 1B, according to an embodiment of the present disclosure.
Fig. 6 is a detailed view of an alternative wick structure of the 2D vapor chamber of Figs. 1A and 1B, according to an embodiment of the present disclosure.
Fig. 7 is a detailed view of another alternative wick structure of the 2D vapor chamber of Figs. 1A and 1B, according to an embodiment of the present disclosure.
Fig. 8 illustrates circle B of an alternative plurality of heat pipes with the first plate of the 2D vapor chamber of Figs. 1A and 1B, according to an embodiment of the present disclosure.
Fig. 9 is a detailed view of circle B of Fig. 8, according to an embodiment of the present disclosure.

### DETAILED DESCRIPTION

The following describes various principles related to 2D vapor chambers by way of reference to specific examples of second plates coupled to first plates, including specific arrangements and examples of wick structures embodying innovative concepts. More particularly, but not exclusively, such innovative principles are described in relation to selected examples of evaporator wick structures and condenser wick structures, and their dispositions within the 2D vapor chambers, and well-known functions or constructions are not described in detail for purposes of succinctness and clarity. Nonetheless, the disclosed principles can be incorporated in various other embodiments of different evaporator wick structures and condenser wick structures, and their dispositions within the 2D vapor chambers to achieve any of a variety of desired outcomes, characteristics, and/or performance criteria.

Thus, evaporator wick structures and condenser wick structures, and their dispositions within the 2D vapor chambers having attributes that are different from those specific examples discussed herein can embody of the innovative principles, and can be used in applications not described herein in detail. Accordingly, embodiments of evaporator wick structures and condenser wick structures, and their dispositions within the 2D vapor chambers not described herein in detail also fall within the scope of this disclosure, as will be appreciated by those of ordinary skill in the relevant art following a review of this disclosure.

Example embodiments as disclosed herein are directed to 2D vapor chambers, wherein a surface of the 2D vapor chamber is thermally coupled to an electronic component, transporting heat away therefrom, and to working fluid inside of the 2D vapor chamber. In response to receiving the heat, a portion of the working fluid transitions from a liquid phase to a gas phase. The gas portion of the working fluid rises and distributes the received heat substantially along the second plate and plurality of heat pipes of the 2D vapor chamber. The second plate and plurality of heat pipes transfer the heat to ambient air outside of the 2D vapor chamber. The working fluid condenses back into a liquid in response to conducting the heat to the second plate and plurality of heat pipes and the liquid returns to a center of the 2D vapor chamber where the cycle is repeated.

The 2D vapor chambers may be configured within an electric or electronics system that includes heat producing electronic components to be cooled.

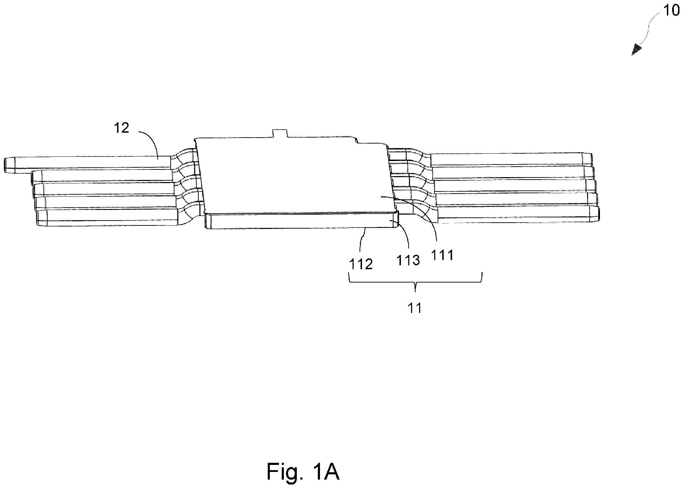

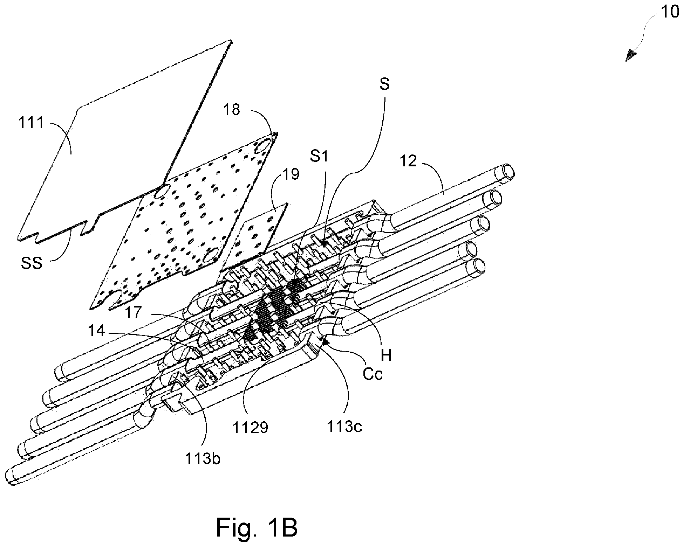

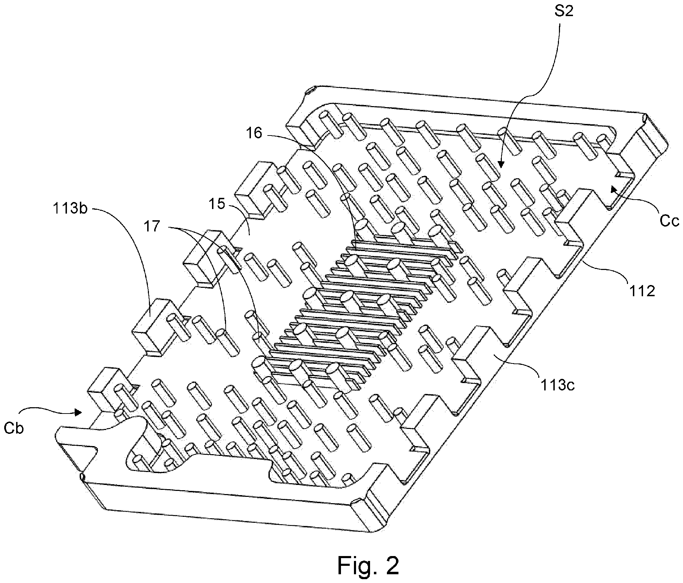

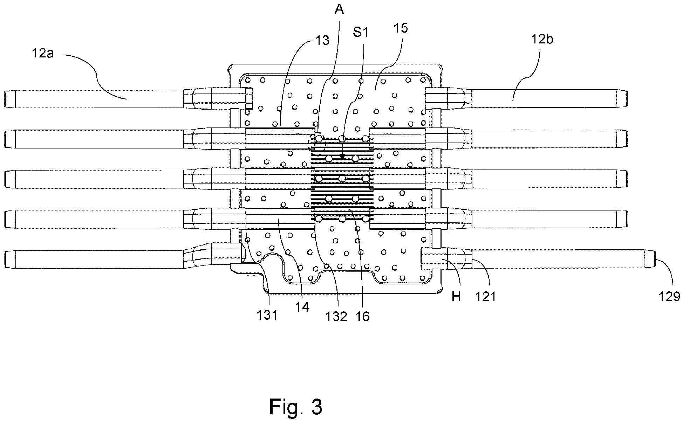

Figs. 1A, 1B, and 2 include at least an embodiment of a 2D vapor chamber 10. The 2D vapor chamber 10 includes a vapor chamber 11 and a plurality of heat pipes 12. The vapor chamber 11 includes a first plate 112, an evaporator wick structure 15, a second plate 111, and a condenser wick structure 18. The first plate 112 includes a first surface (not shown), a plurality of chamber walls 113, and a plurality of support structures 17. The plurality of support structures 17 is coupled to and extends from the first surface. The plurality of chamber walls 113 surrounds and extends from a perimeter of the first surface. The plurality of chamber walls 113 includes a first plate perimeter ledge 1129 opposite the perimeter. The plurality of chamber walls 113 includes a second chamber wall 113b and a third chamber wall 113c opposite the second chamber wall 113b. The second chamber wall 113b includes a plurality of second cut outs Cb and the third chamber wall 113c includes a plurality of third cut outs Cc. The evaporator wick structure 15 includes a first surface wick portion 15 disposed on the first surface. The second plate 111 includes a second surface and a second plate perimeter portion SS. The second plate perimeter portion surrounds the second surface (not shown) and the second plate perimeter portion SS is coupled to the first plate perimeter ledge 1129. The condenser wick structure 18 is disposed on the second surface. The plurality of heat pipes 12 includes a plurality of second heat pipes 12a and a plurality of third heat pipes 12b (see Fig. 3). Each plurality of heat pipes 12 respectively includes an inner chamber surface (not shown) and a pipe wick structure (not shown). The pipe wick structure is disposed on the inner chamber surface. Each plurality of second heat pipes 12a respectively abuts each plurality of second cut outs Cb and the second plate perimeter portion SS and extends in a second direction from the second chamber wall 113b. Each plurality of third heat pipes 12b respectively abuts each plurality of third cut outs Cc and the second plate perimeter portion and extends in a third direction from the third chamber wall 113c. The pipe wick structure is coupled to the evaporator wick structure 15.

In some embodiments, the first plate 112 and the second plate 111 define an interior cavity S. The interior cavity 5 includes a heat transfer portion S1 and a vapor portion S2. The heat transfer portion S1 is centrally disposed in the interior cavity 5 from a central first surface to a central second surface. The vapor portion S2 surrounds the heat transfer portion S1 from a surrounding first surface to a surrounding second surface and from the heat transfer portion S1 to the plurality of chamber walls 113. Each plurality of heat pipes 12 is respectively fluidly coupled to the interior cavity S.

In some embodiments, the 2D vapor chamber 10 further includes a core condenser wick structure 19. The core condenser wick structure 19 is coupled to and extends from the condenser wick structure 18. The core condenser wick structure 19 is disposed in the heat transfer portion S1.

In some embodiments, the plurality of support structures 17 abuts the second surface.

In some embodiments, each plurality of heat pipes 12 respectively includes a closed end 129, an open end 121, and a connector portion H. The open end 121 is opposite the closed end 129 and the connector portion H is coupled to the open end 121. The connector portion H of each plurality of second heat pipes 12a respectively abuts each plurality of second cut outs Cb and the second plate perimeter portion. The connector portion H of each plurality of third heat pipes 12b respectively abuts each plurality of third cut outs Cc and the second plate perimeter portion. In some embodiments, the connector portion H of each plurality of heat pipes 12 includes a flat heat pipe and the plurality of heat pipes 12 includes a round heat pipe. In some embodiments, the connector portion H of each plurality of heat pipes 12 includes a flat heat pipe and the plurality of heat pipes 12 includes a flat heat pipe.

In some embodiments, the first plate 112 includes a plurality of heat transfer structures 16. Each plurality of heat transfer structures 16 is coupled to and extends from the first surface in the heat transfer portion S1. One or more plurality of heat transfer structures 16 is integrally formed with one or more plurality of support structures 17.

In some embodiments, each plurality of heat transfer structures 16 respectively includes a heat structure length and a cuboid shape. The heat structure length includes a length and the cuboid shape includes a shape. Each plurality of heat transfer structures 16 is parallel disposed on the first surface in the heat transfer portion S1 with the second direction and with the third direction, longitudinally. In some embodiments, the plurality of heat transfer structures 16 is not parallel disposed on the first surface in the heat transfer portion S1.

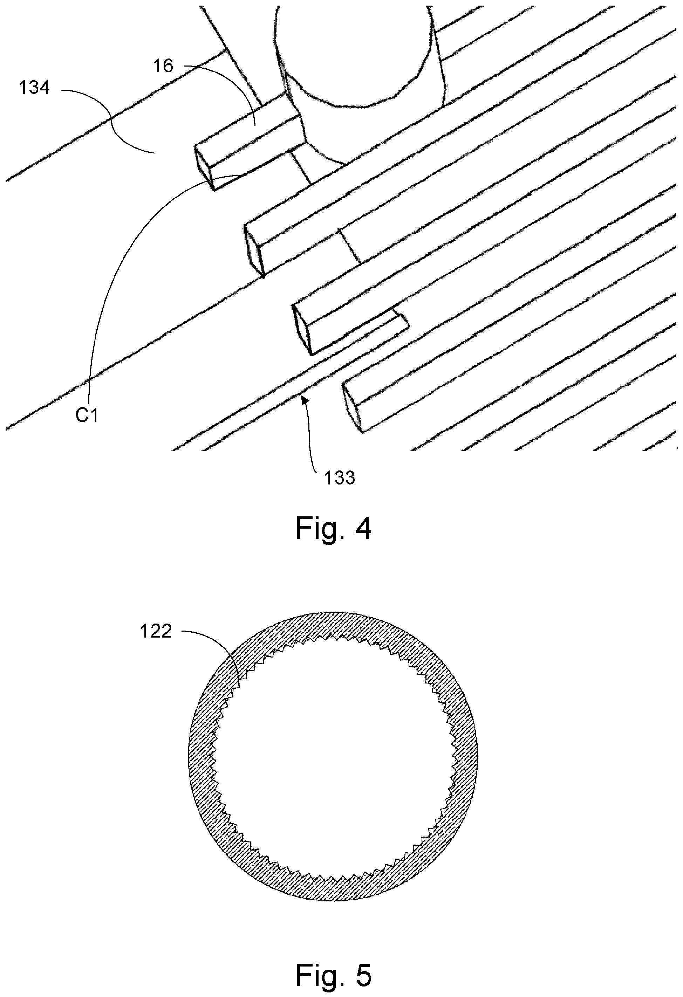

In some embodiments, one or more plurality of heat pipes 12 respectively includes an extension portion 13 (see Fig. 3). The extension portion 13 includes a bottom surface 133 (see Fig. 4) and an exposed inner chamber surface (not shown). The exposed inner surface is on an opposite side of the bottom surface 133. The pipe wick structure (not shown) includes a pipe wick portion (not shown) and an extension wick portion 14. The pipe wick portion is disposed on the inner chamber surface. The extension wick portion 14 is disposed on the exposed inner chamber surface. The extension wick portion 14 is coupled to the pipe wick portion and coupled to the evaporator wick structure 15. In some embodiments, the extension portion 13 is formed by cutting off a respective top end portion of the plurality of heat pipes 12. In some embodiments, the extension portion 13 is formed by respective coupling to the connector portion H via, as an example, a welding process.

In some embodiments, the bottom surface 133 is coupled to the first surface. In some embodiments, the bottom surface 133 is coupled to the first surface via, as an example, a welding process. In some embodiments, the extension wick portion 14 is integrally formed with the evaporator wick structure 15. In some embodiments, the extension wick portion 14 is formed with the evaporator wick structure 15 via, as an example, metal bonding.

In some embodiments, the bottom surface 133 is coupled to the evaporator wick structure 15. In some embodiments, the extension wick portion 14 is integrally formed with the pipe wick portion.

In some embodiments, the evaporator wick structure 15 includes a heat transfer wick portion. The heat transfer wick portion is disposed on the plurality of heat transfer structures 16. The extension wick portion 14 is coupled to the heat transfer wick portion.

Figs. 3 and 4 illustrate at least an embodiment of a detailed view of circle A of a plurality of heat pipes 12 with the first plate 112 of the 2D vapor chamber 10. In some embodiments, the extension portion 13 is respectively coupled to the plurality of heat transfer structures 16. In some embodiments, the extension portion 13 includes a connector end 131 and a cavity end 132. The cavity end 132 includes a base cut out C1. The connector end 131 is coupled to the connector portion H and the base cut out C1 abuts the plurality of heat transfer structures 16. In some embodiments, the cavity end 132 is respectively coupled to the plurality of heat transfer structures 16 via an adhesive or a welding process.

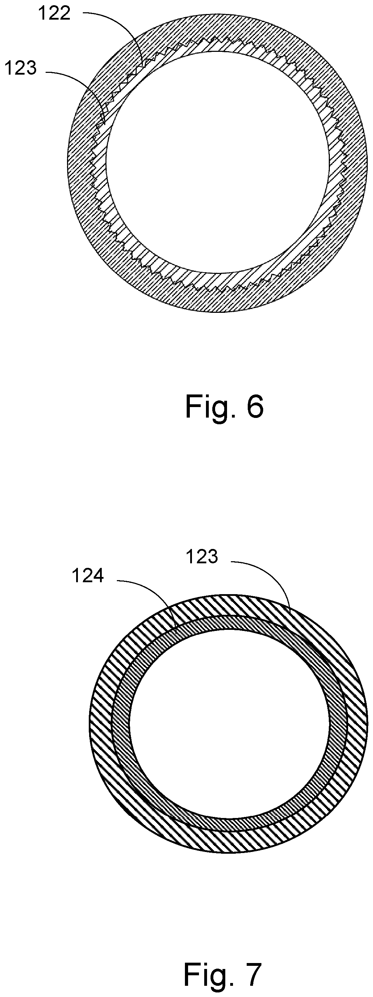

Figs. 5, 6 and 7 are detailed views of wick structures of the 2D vapor chamber 10. Fig. 5 is a detailed view of a grooved wick 122, Fig. 6 is a detailed view of a sintered powder wick 123 on a grooved wick 122, and Fig. 7 is a detailed view of a flat wick structure 124 on a sintered powder wick 123. In some embodiments, the evaporator wick structure 15 includes at least one of a grooved wick, a sintered metal powder wick, a metal mesh wick, and a sintered ceramic powder wick, and any of a foregoing combination. In some embodiments, the condenser wick structure 18 includes at least one of a grooved wick, a sintered metal powder wick, a metal mesh wick, and a sintered ceramic powder wick, and any of a foregoing combination. In some embodiments, the pipe wick structure includes at least one of a grooved wick, a sintered metal powder wick, a metal mesh wick, and a sintered ceramic powder wick, and any of a foregoing combination. In some embodiments, a material of the evaporator wick structure 15, condenser wick structure 18, and pipe wick structure can be gold, silver, copper or iron.

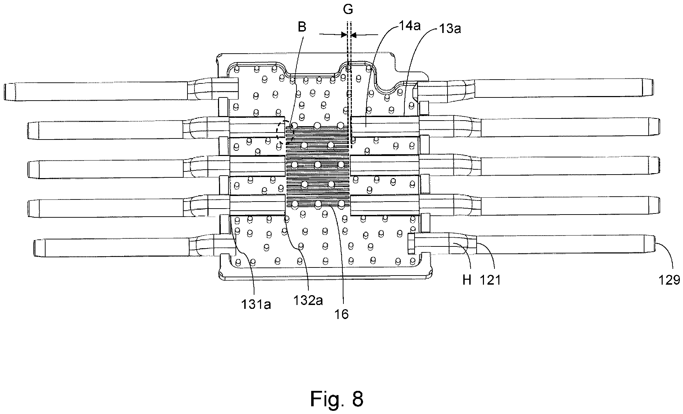

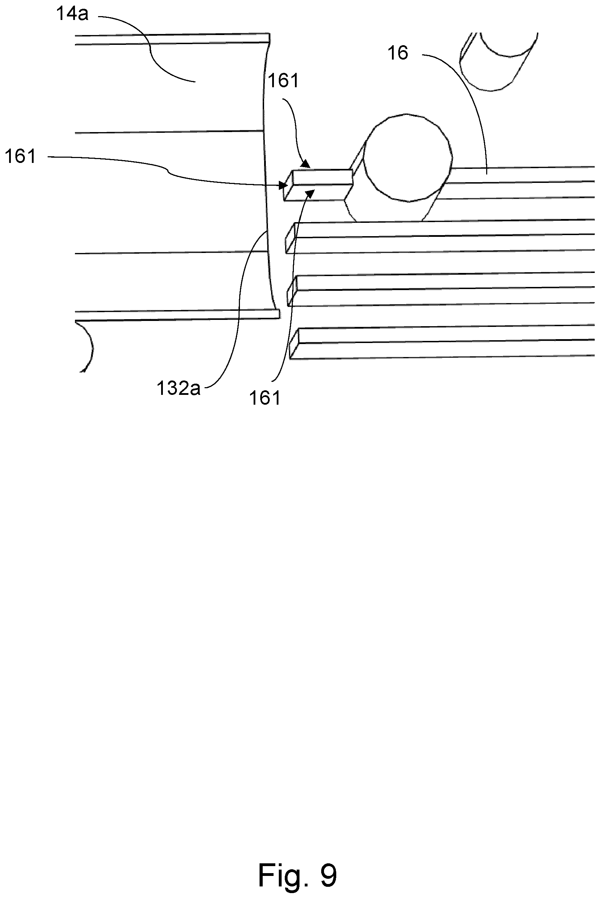

Figs. 8 and 9 illustrate at least an alternative embodiment of a detailed view of circle B of a plurality of heat pipes 12 with the first plate 112 of the 2D vapor chamber 10. In some embodiments, the 2D vapor chamber 10 further includes a vapor gap G. The vapor gap G is respectively between the extension portion 13a and the plurality of heat transfer structures 16. In some embodiments, each plurality of heat transfer structures 16 includes a plurality of outer surfaces 161. In some embodiments, the transfer wick portion is disposed one or more of the plurality of outer surfaces 161 of the plurality of heat transfer structures 16

The 2D vapor chamber 10 of the present disclosure increases surface area, thereby increasing working fluid pathways to increase heat dissipation efficiency. The condenser wick structure 18 speeds up transport of condensed working fluid back to the first surface opposite the heat source. Moreover, the plurality of heat pipes 12 increases surface area within the vapor portion S2 and even further increases condensation surfaces, improving thermal performance of the 2D vapor chamber 10. Furthermore, the core condenser wick structure 19 extends from the condenser wick structure 18 in the heat transfer portion S1, to even further accelerate transport of the condensed working fluid. Also, the first surface wick portion 15 and the base structure wick portion of the evaporator wick structure 15 further enhances transport of condensed working fluid back to the first surface. Moreover, the extension wick portion 14 of the extension portion 13, coupled to the pipe wick portion and the evaporator wick structure 15, further drives condensed working fluid to flow from the plurality of heat pipes 12 to the heat transfer wick portion and the evaporator wick structure 15, adding to the effectiveness of the 2D vapor chamber 10 to dissipate heat via the phase change (liquid-vapor-liquid) mechanism, increasing the thermal performance of the 2D vapor chamber 10, as an example, by as much as 20% to 30%. Thus, overheating of electronic components of thin and compact electronic device is prevented as the generated heat of the electronic component is more efficiently distributed along the 2D vapor chamber 10 and the condensed working fluid is more efficiently transported back to the first surface opposite the heat source to adequately cool the electronic component.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean than one of the element that it introduces.

## Claims

1. A 2D vapor chamber (10), comprising:
a first plate (112), the first plate (112) includes a first surface, a plurality of chamber walls (113), and a plurality of support structures (17), the plurality of support structures (17) coupled to and extends from the first surface, the plurality of chamber walls (113) surrounds and extends from a perimeter of the first surface, the plurality of chamber walls (113) includes a first plate perimeter ledge (1129), the first plate perimeter ledge (1129) opposite the perimeter, the plurality of chamber walls (113) includes a second chamber wall (113b) and a third chamber wall (113c), the third chamber wall (113c) opposite the second chamber wall (113b), the second chamber wall (113b) includes a plurality of second cut outs (Cb), the third chamber wall (113c) includes a plurality of third cut outs (Cc);
an evaporator wick structure (15), the evaporator wick structure (15) includes a first surface wick portion, the first surface wick portion disposed on the first surface;
a second plate (111), the second plate (111) includes a second surface and a second plate perimeter portion (SS), the second plate perimeter portion (SS) surrounds the second surface, the second plate perimeter portion (SS) coupled to the first plate perimeter ledge (1129);
a condenser wick structure (18), the condenser wick structure (18) disposed on the second surface; and
a plurality of heat pipes (12), the plurality of heat pipes (12) includes a plurality of second heat pipes (12a) and a plurality of third heat pipes (12b), each plurality of heat pipes (12) respectively includes an inner chamber surface and a pipe wick structure, the pipe wick structure disposed on the inner chamber surface, each plurality of second heat pipes (12a) respectively abuts each plurality of second cut outs (Cb) and the second plate perimeter portion (SS) and extends in a second direction from the second chamber wall (113b), and each plurality of third heat pipes (12b) respectively abuts each plurality of third cut (Cc) outs and the second plate perimeter portion (SS) and extends in a third direction from the third chamber wall (113c), the pipe wick structure coupled to the evaporator wick structure (15).

2. The 2D vapor chamber (10) of claim 1, wherein the first plate (112) and the second plate (111) define an interior cavity (S), the interior cavity (S) includes a heat transfer portion (S1) and a vapor portion (S2), the heat transfer portion (S1) centrally disposed in the interior cavity (S) from a central first surface to a central second surface, the vapor portion (S2) surrounds the heat transfer portion (S1) from a surrounding first surface to a surrounding second surface and from the heat transfer portion (S1) to the plurality of chamber walls (113), each plurality of heat pipes (12) respectively fluidly coupled to the interior cavity.

3. The 2D vapor chamber (10) of claim 2, further comprising a core condenser wick structure (19), the core condenser wick structure (19) coupled to and extends from the condenser wick structure (18), the core condenser wick structure (19) disposed in the heat transfer portion (S1).

4. The 2D vapor chamber (10) of any one of claims 1 to 3, wherein each plurality of heat pipes (12) respectively includes a closed end (129), an open end (121), and a connector portion (H), the open end (121) opposite the closed end (129), the connector portion (H) coupled to the open end (121), the connector portion (H) of each plurality of second heat pipes (12a) respectively abuts each plurality of second cut outs (Cb) and the second plate perimeter portion (SS), and the connector portion (H) of each plurality of third heat pipes (12b) respectively abuts each plurality of third cut outs (Cc) and the second plate perimeter portion (SS).

5. The 2D vapor chamber (10) of claim 2, 3 or 4, wherein the first plate (112) includes a plurality of heat transfer structures (16), each plurality of heat transfer structures (16) coupled to and extends from the first surface in the heat transfer portion (S1), one or more plurality of heat transfer structures (16) integrally formed with one or more plurality of support structures (17).

6. The 2D vapor chamber (10) of claim 5, wherein each plurality of heat transfer structures (16) respectively includes a heat structure length and a cuboid shape, the heat structure length includes a length, the cuboid shape includes a shape, each plurality of heat transfer structures (16) parallel disposed on the first surface in the heat transfer portion (S1) with the second direction and with the third direction, longitudinally.

7. The 2D vapor chamber (10) of claim 5, wherein one or more plurality of heat pipes (12) respectively includes an extension portion (13), the extension portion (13) includes a bottom surface (133) and an exposed inner chamber surface, and wherein the pipe wick structure includes a pipe wick portion and an extension wick portion (14), the pipe wick portion disposed on the inner chamber surface, the extension wick portion (14) disposed on the exposed inner chamber surface, the extension wick portion (14) coupled to the pipe wick portion and coupled to the evaporator wick structure (15).

8. The 2D vapor chamber (10) of claim 7, wherein the bottom surface (133) is coupled to the first surface.

9. The 2D vapor chamber (10) of claim 7, wherein the bottom surface (133) is coupled to the evaporator wick structure (15).

10. The 2D vapor chamber (10) of claim 7, wherein the evaporator wick structure (15) includes a heat transfer wick portion, the heat transfer wick portion disposed on the plurality of heat transfer structures (16), the extension wick portion (14) coupled to the heat transfer wick portion.

11. The 2D vapor chamber (10) of claim 10, wherein the extension portion (13) is respectively coupled to the plurality of heat transfer structures (16).

12. The 2D vapor chamber (10) of claim 11, wherein the extension portion (13) includes a connector end (131) and a cavity end (132), the cavity end (132) includes a base cut out (C1), the connector end (131) coupled to the connector portion (H), the base cut out (C1) abuts the plurality of heat transfer structures (16).

13. The 2D vapor chamber (10) of claim 10, further comprising a vapor gap (G), the vapor gap (G) respectively between the extension portion (13a) and the plurality of heat transfer structures (16).

14. The 2D vapor chamber (10) of any one of claims 1 to 13, wherein the plurality of support structures (17) abuts the second surface.

15. The 2D vapor chamber (10) of any one of claims 1 to 14, wherein the evaporator wick structure (15) includes at least one of a grooved wick, a sintered metal powder wick, a metal mesh wick, and a sintered ceramic powder wick, and any of a foregoing combination.

16. The 2D vapor chamber (10) of any one of claims 1 to 15, wherein the condenser wick structure (18) includes at least one of a grooved wick, a sintered metal powder wick, a metal mesh wick, and a sintered ceramic powder wick, and any of a foregoing combination.

17. The 2D vapor chamber (10) of any one of claims 1 to 16, wherein the pipe wick structure includes at least one of a grooved wick, a sintered metal powder wick, a metal mesh wick, and a sintered ceramic powder wick, and any of a foregoing combination.
